## Europäisches Patentamt
## European Patent Office
## Office européen des brevets

(19)

(11) Veröffentlichungsnummer: **0 031 898**
A1

(12)

# EUROPÄISCHE PATENTANMELDUNG

(21) Anmeldenummer: **80107491.5**

(22) Anmeldetag: **29.11.80**

(51) Int. Cl.$^3$: **H 01 L 21/78**
H 01 L 29/06, H 01 L 29/743
H 01 L 21/302

(30) Priorität: **18.12.79 CH 11233/79**

(43) Veröffentlichungstag der Anmeldung:
**15.07.81 Patentblatt 81/28**

(84) Benannte Vertragsstaaten:
**DE FR GB IT**

(71) Anmelder: **Tag Semiconductors Limited, Wilmington Zürich Branch**
**Hohlstrasse 608-612**
**CH-8048 Zürich(CH)**

(72) Erfinder: **Reimers, Peter, Dr. Dipl.-Phys. Dr. rer. nat.**
**Poststrasse 170**
**CH-8957 Spreitenbach(CH)**

(72) Erfinder: **Aujla, Jaswinder Singh, B.Sc. M.Sc.**
**Kirchgasse 9**
**CH-8907 Wettswil(CH)**

(74) Vertreter: **Blum, Rudolf Emil Ernst et al,**
**c/o E. BLUM & CO. Vorderberg 11**
**CH-8044 Zürich(CH)**

(54) Verfahren zum Erzeugen von dotierten Bereichen zur gegenseitigen elektrischen Isolation einzelner Halbleiterelemente auf einer Siliziumscheibe, sowie nach dem Verfahren hergestellte Halbleiteranordnung.

(57) Um bei Thyristoren, die in Planartechnik hergestellt sind, Sperrspannungen von mindestens 800V in beiden Richtungen zur erreichen, wird ein n-leitender Basisbereich (7) genügend dick ausgebildet, um die bei solchen Spannungen entstehenden Raumladungszonen ohne Gefahr von vorzeitigen Durchbrüchen aufnehmen zu können. Die Dicke ($W_3$) des Basisbereichs (7) beträgt mindestens ca. 110 $\mu$m, was eine Gesamtdicke des Thyristors (1) von mindestens 200 $\mu$m ergibt. Um dennoch die Diffusion der p-leitenden Isolationsbereiche (8) durch die gesamte Randpartie jedes Elementes (1) zu ermöglichen, die vor der Vereinzelung einer Siliziumeinkristallscheibe (2) erfolgt, wird ein Grubenmuster (9) in das Silizium geätzt. Die Gruben weisen eine Tiefe (H) von ca. 80 $\mu$m auf. Die ermöglichen in zweckmässiger Weise die Diffusion der Randpartien (8) und erlauben die leichtere Vereinzelung der Elemente (1).

Fig. 1

-1-

Verfahren zum Erzeugen von dotierten Bereichen zur gegenseitigen elektrischen Isolation einzelner Halbleiterelemente auf einer Siliziumscheibe, sowie nach dem Verfahren hergestellte Halbleiteranordnung

---

Die Erfindung betrifft ein Verfahren zum Erzeugen von dotierten Bereichen zur gegenseitigen elektrischen Isolation einzelner Halbleiterelemente auf einer Siliziumscheibe von mindestens 150 $\mu$m Dicke mittels Diffusion zwischen den Oberflächen, sowie eine gemäss dem Verfahren hergestellte Halbleiteranordnung.

Bei der in der Planartechnik bekannten Isolationsdiffusion, welche zur elektrischen Isolation der auf einer Siliziumscheibe, einem sogenannten Wafer, angeordneten Halbleiterelement dient, die nach Vereinzelung als sogenannte Chips Verwendung finden, wird ein sich in den Isolationsbereichen über die ganze Scheibendicke erstreckender dotierter Bereich erzeugt. Dies wird mittels Diffusion von beiden Scheibenoberflächen her erzielt. Dabei stiess man bezüglich der verwendbaren Scheibendicke auf Grenzen, oberhalb deren eine wirtschaftliche Durchführung dieses Verfahrensschrittes nicht mehr gewährleistet war. Dies deshalb, weil die Diffusionszeit mit zunehmender Diffusionstiefe stark zunimmt. Ferner ist eine tiefe Diffusion mit entsprechender

Sb/cj
23.6.80                                                        EU 1047

lateraler Diffusion an den Oberflächen verbunden, was oft unerwünscht ist und eine Grenze für die Miniaturisierung der Halbleiterelemente darstellt.

Diese Umstände haben zur Folge, dass bisher keine in Planartechnik ausgeführten steuerbaren Siliziumgleichrichter, sogenannte Thyristoren, erhältlich sind, welche in Vorwärts- und Rückwärtsrichtung regelmässig Sperrspannungen von wesentlich mehr als 400 V aufnehmen können, indem die Grösse der aufzunehmenden Sperrspannungen von der verwendbaren Scheibendicke abhängt.

Die Erfindung stellt sich die Aufgabe, ein Verfahren bereitzustellen, sowie eine entsprechende Anordnung anzugeben, mittels derer die Isolationsdiffusion auch bei grossen Scheibendicken in wirtschaftlicher Zeit ausführbar ist, indem die effektive Diffusionstiefe verringerbar ist, mittels derer eine Verminderung der lateralen Diffusion an der Oberfläche erzielt werden kann. Ferner sollen die Halbleiterelemente trotz grösserer Scheibendicke leicht vereinzelbar sein.

Dies wird erfindungsgemäss dadurch erreicht, dass längs den zu erzeugenden Isolationsbereichen an mindestens einer der Oberflächen vor dem Diffusionsvorgang Gruben erzeugt werden und die Diffusion danach von beiden Oberflächen her und auf der mit Gruben versehenen Seite durch die Grubenwände erfolgt.

Die nach dem Verfahren hergestellte Halbleiteranordnung ist dadurch gekennzeichnet, dass jedes Halbleiterelement an seinem Rand eine gegenüber seinem zentralen Teil um die Grubentiefe verringerte Dicke aufweist.

Eine vorteilhafte Ausführungsform der Erfindung wird durch eine Halbleiteranordnung in planarem Aufbau dargestellt, wobei die Halbleiterelemente steuerbare Siliziumgleichrichter sind, welche zwischen einer oberen und unteren Grenzfläche mindestens vier dotierte Bereiche aufweisen, wobei aneinandergrenzende Bereiche jeweils von entgegengesetztem Leitfähigkeitstyp sind und wobei eine n-leitende Basis von einer Anode an der unteren Grenzfläche durch einen p-leitenden Bereich getrennt ist, welcher sich in der Randpartie des Elementes zwischen der unteren und der oberen Grenzfläche erstreckt und die dadurch gekennzeichnet ist, dass die n-leitende Basis in ihrer zentralen Partie eine Dicke ($W_3$) von mindestens 110 µm aufweist.

Die Erfindung gestattet, dickere Halbleiteranordnungen in Planartechnik herzustellen, als bisher.

Die Gruben längs der Randzonen der Elemente ergeben eine wirtschaftliche Diffusionszeit zur Diffusion ihrer Randpartien, der sogenannten Isolationsbereiche, in die Halbleiteranordnung und erlauben es, die Breite dieser Isolationsbereiche an der oberen Grenzfläche klein zu halten, wodurch die gesamte Breite der Elemente vermindert werden kann.

Nachfolgend wird anhand der Zeichnung ein Ausführungsbeispiel der Erfindung näher erläutert. Es zeigen:

Fig. 1 einen Querschnitt durch ein steuerbares Gleichrichterelement,

Fig. 2 eine schematische Darstellung der eingeätzten Gruben im Querschnitt, und

Fig. 3 eine schematische Darstellung in Aufsicht auf ein Grubenmuster.

Zunächst ist allgemein festzuhalten, dass die hier angegebenen Masse jeweils vorgegebene Idealwerte sind, welche in der Praxis nur innerhalb bestimmter Toleranzen eingehalten werden können, wie dem Fachmann bekannt ist.

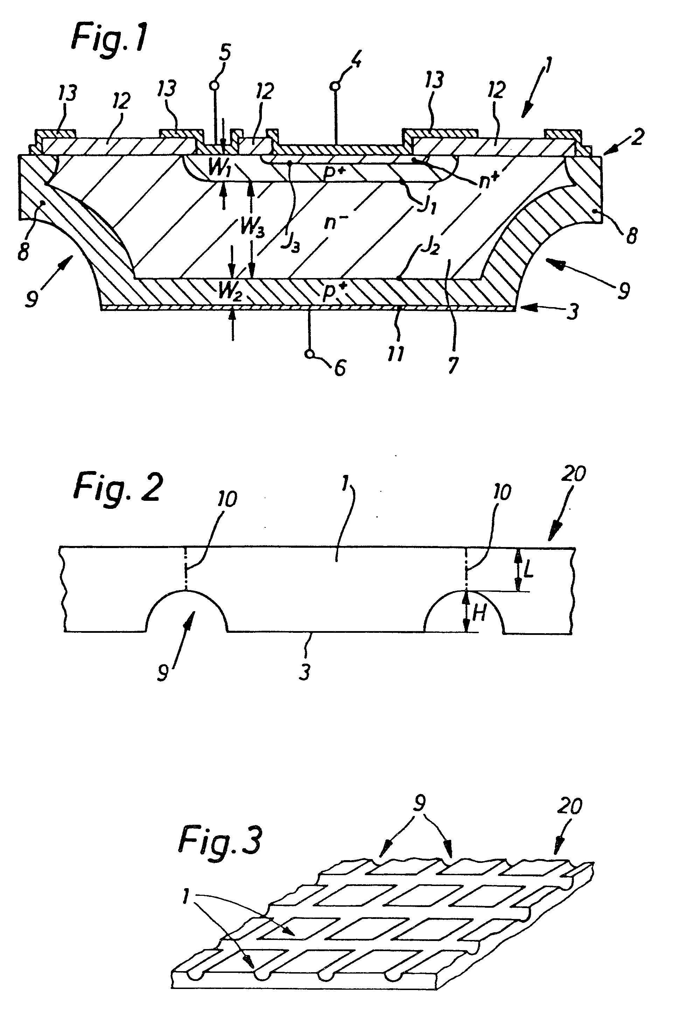

In Fig. 1 ist eine gemäss der Erfindung ausgebildete planare Halbleiteranordnung im Querschnitt dargestellt, und zwar als einzelnes Thyristorelement 1, das von einer Halbleiterscheibe 20, wie sie schematisch in den Fig. 2 und 3 dargestellt ist, abgetrennt wurde. Die Herstellung der Elemente 1 erfolgt in bekannter Weise auf einer Siliziumeinkristallscheibe 20, einem sogenannten Wafer, die zur Vereinzelung der Elemente 1, welche auch als Chip bezeichnet werden, längs einem Raster zerteilt wird. An der oberen Grenzfläche 2 des Elementes 1 ist eine Kathode 4 sowie eine Torelektrode 5 angeordnet, während an der unteren Grenzfläche 3 eine Anode 6 ausgebildet ist. Um die Sperrspannung von mindestens 800V in Vorwärts- und Rückwärtsrichtung aufnehmen zu können, ist eine n-leitende Basis 7 nötig, welche mit mindestens $W_3$ = 110 $\mu$m dicker ist als der entsprechende Bereich bekannter Elemente dieser Art. Dies gewährleistet, dass die bei der Sperrung entstehenden Raumladungszonen sich ohne Gefahr eines vorzeitigen Durchbruchs (punch through) ausreichend in der Basis ausbreiten können. Zur Reduktion des sogenannten Kurveneffektes an den gekrümmten Bereichen des kathodenseitigen pn-Ueberganges $J_1$ der n-leitenden Basis 7 wird dessen Tiefe mit mindestens $W_1$ = 50 $\mu$m festgelegt. Damit können die Krümmungen an diesem Uebergang herabgesetzt werden, was sich wiederum auf die Gestalt der entstehenden Raumladungszonen günstig auswirkt. Die Tiefe $W_2$ des anodenseitigen pn-Ueberganges $J_2$ der Basis 7 wird aus prozesstechnischen Gründen mindestens 40 $\mu$m gewählt, wodurch Beeinträchtigungen durch die beim Auflöten des Elementes 1 in der unteren Grenzfläche 3 entstehenden mechanischen Verspannungen bei hohen Sperrspannungen in Rückwärtsrichtung vermieden werden.

Die einzelnen Elemente 1 müssen durch eine in der Planartechnologie erforderliche Diffusion auf der Halbleiterscheibe elektrisch voneinander isoliert werden. Um dies innerhalb einer vertretbaren Zeitdauer bei einer Scheibendicke von $W_1+W_2+W_3$ = 200 $\mu$m zu erreichen, wird die Scheibendicke in den entsprechenden Isolationsbereichen 8 durch eine Grubenätzung 9 im Silizium von vorteilhaft ca. 80 $\mu$m Tiefe auf ca. L = 120 $\mu$m (Fig. 2) herabgesetzt. Damit kann die Isolationsdiffusionsdauer auch bei grossen Scheibendicken in der bisherigen Grössenordnung gehalten werden. Gleichzeitig wird dadurch erreicht, dass das Vereinzeln der Elemente 1 der fertig fabrizierten Halbleiterscheibe 20 trotz der Dicke der Elemente 1 an den Isolationsbereichen 8 durch einen bekannten Ritz- und Brechprozess möglich ist.

Dies deshalb, weil die Dicke der Scheibe an den Brechstellen 10 (Fig. 2) nur L = 120 $\mu$m beträgt.

Schliesslich wird durch die Grubenätzung das Verhältnis von Elementgrösse zu Durchlassstrom minimalisiert, indem die Breite der Isolationsdiffusion 8 an der oberen Grenzfläche 2 vermindert werden kann.

Die Grubenätzung tritt beim einzelnen Thyristorelement 1 als bogenförmige Ausnehmung 9 längs der anodenseitigen Randpartie in Erscheinung. An der sich zwischen den Ausnehmungen 9 erstreckenden ebenen, unteren Grenzfläche 3 befindet sich eine anodenseitige, eutektische Gold-Silizium-Metallisierung 11, welche die Montage des Elementes 1 in Gehäusen wie z.B. TO-92, TO-126, TO-202, TO-18 oder TO-39 erlaubt.

Die an der oberen Grenzfläche 2 des Elementes 1 an die Oberfläche stossenden pn-Uebergänge zwischen den einzelnen Bereichen sind in bekannter Weise durch eine $SiO_2$-Schicht 12 passiviert, die eine Dicke von 1.5 - 2 $\mu$m aufweist.

Auf der Kathodenseite des Elementes 1 wird zudem mittels Aluminium-Metallisierung eine sogenannte Feldplattenkonfiguration 12 erzeugt. Damit wird die positive Grenzflächenladung zwischen dem Silizium des Elementes 1 und dem Siliziumdioxyd der aufgebrachten Schicht 12 kompensiert. Die Aluminium-Metallisierung überlappt die zwei sperrenden pn-Uebergänge $J_1$ bzw. $J_2$. Dies beeinflusst die Raumladungs-zone derart, dass bei Sperrspannungen von 800V die Gefahr eines vorzeitigen Durchbruchs unter dem Einfluss der erwähnten Grenzflächenladung vermieden wird. Ferner wird mit der Feldplattenkonfiguration 13 eine Langzeitstabilität der 800 V Sperrspannung im Temperaturbereich zwischen -40$^\circ$C und 150$^\circ$C erreicht.

Wie bereits erwähnt, erfolgt die Herstellung der Elemente auf einer Siliziumeinkristallscheibe 20, wie dies schematisch in den Fig. 2 und 3 ersichtlich ist. Die dabei vorzunehmenden Prozessschritte sind dem Fachmann bekannt und sollen deshalb nicht im einzelnen erläutert werden. Abweichend vom Bekannten wird bei der Herstellung des hier beschriebenen Thyristors vor der Diffusion der p-leitenden Randpartien 8 anodenseitig ein gitterartiges Grubenmuster 9 ins Silizium geätzt. Die Tiefe der Gruben 9 beträgt vorteilhaft, wie bereits erwähnt, 80 μm, so dass bei einer Gesamtdicke von 200 μm eine minimale Restdicke von 120 μm verbleibt. Die Maskierung der Siliziumscheibe kann abweichend von dem in Fig. 3 gezeigten Beispiel so erfolgen, dass die entstehenden Inseln zwischen den Gruben 9 an ihren Ecken leicht abgerundet sind.

Das Grubenmuster auf der Scheibe 20 wird vorzugsweise nicht bis an den Scheibenrand hinaus erzeugt, sondern derart, dass am Rand ein grubenfreier Ring von mindestens 2 mm Breite verbleibt, welcher der Anordnung die nötige mechanische Stabilität verleiht und ein vorzeitiges Brechen entlang einer Grube verhindert.

Die Auftrennung der Siliziumscheibe 20 in die einzelnen Elemente 1 erfolgt durch Ritzung an der Trennstelle 10, die am Ort minimaler Scheibendicke liegt, und nachfolgendem Brechen.

Die quadratischen Elemente 1 weisen je nach den zu steuernden Strömen Kantenlängen von ca. 1000 μm (1A) bzw. 1500 μm (4A) auf. Der beschriebene Planarthyristor mit Sperrschaltungen von 800V in Vorwärts- und Rückwärtsrichtung lässt sich für Durchlassströme von 1A bis 10A und Zündströme von 5 nA bis 50 mA herstellen.

Er weist im Vergleich zu bekannten Planarthyristoren den Vorteil höherer Sperrspannung in beiden Richtungen auf, ohne dass ein wesentlich grösserer Herstellungsaufwand nötig ist. Durch die Grubenätzung 9 wird ein leichtes Vereinzeln der Siliziumscheibe 20 in Elemente 1 ermöglicht. Ferner erleichtert die Grube bei der Herstellung die sogenannte Getterung zur Entfernung von Verunreinigungen, da einerseits die Fläche für die Getterung vergrössert wird, andererseits die Tiefe leichter erreichbar ist. Die Grubenätzung erlaubt es, die sperrende Basis 7 ausreichend dick zur Aufnahme der bei höherer Sperrspannung erweiterten Raumladungszone auszugestalten, ohne die Diffusion der Isolationsbereiche 8 zu verunmöglichen.

PATENTANSPRUECHE

1. Verfahren zum Erzeugen von dotierten Bereichen (8) zur gegenseitigen elektrischen Isolation einzelner Halbleiterelemente (1) auf einer Siliziumscheibe (20) von mindestens 150 μm Dicke mittels Diffusion zwischen den Oberflächen (2,3), dadurch gekennzeichnet, dass längs den zu erzeugenden Isolationsbereichen (8) an mindestens einer der Oberflächen vor dem Diffusionsvorgang Gruben (9) erzeugt werden und die Diffusion danach von beiden Oberflächen her und auf der mit Gruben versehenen Seite durch die Grubenwände erfolgt.

2. Verfahren nach Anspruch 1, dadurch gekennzeichnet, dass die Gruben (9) eingeätzt werden.

3. Verfahren nach Anspruch 1, dadurch gekennzeichnet, dass die Gruben (9) auf der Siliziumscheibe (20) in gitterförmigem Muster angeordnet werden, wobei längs des Scheibenrandes ein Bereich grubenfrei verbleibt.

4. Verfahren nach Anspruch 1, dadurch gekennzeichnet, dass die Siliziumscheibe (20) zur Vereinzelung den Gruben (9) entlang gebrochen wird.

5. Halbleiteranordnung, hergestellt nach dem Verfahren gemäss Anspruch 1, dadurch gekennzeichnet, dass jedes Halbleiterelement an seinem Rand (8) eine gegenüber seinem zentralen Teil um die Grubentiefe verringerte Dicke aufweist.

6. Halbleiteranordnung nach Anspruch 5 in planarem Aufbau, wobei die Halbleiterelemente (1) steuerbare Siliziumgleichrichter sind, welche zwischen einer oberen (2) und einer unteren (3) Grenzfläche mindestens vier dotierte Bereiche aufweisen, wobei aneinandergrenzende Bereiche jeweils von entgegengesetztem Leitfähigkeitstyp (n,p) sind und wobei eine n-leitende Basis (7) von einer Anode (6,11) an der unteren Grenzfläche (3) durch einen p-leitenden Isolationsbereich getrennt ist, welcher sich in der Randpartie (8) des Elementes (1) zwischen der unteren und der oberen Grenzfläche erstreckt, dadurch gekennzeichnet, dass die n-leitende Basis (7) in ihrer zentralen Partie eine Dicke $(W_3)$ von mindestens 100 $\mu$m aufweist.

7. Halbleiteranordnung nach Anspruch 6, wobei die an der oberen Grenzfläche (2) mündenden Uebergänge $(J_1, J_2, J_3)$ zwischen den dotierten Bereichen von einer $SiO_2$-Passivierungsschicht (12) überdeckt sind, dadurch gekennzeichnet, dass darüber eine Feldplatten-Aluminiumschicht (13) derart angeordnet ist, dass sie jeweils die Uebergänge $(J_1, J_2)$ zwischen der n-leitenden Basis (7) und den angrenzenden p-leitenden Bereichen an der oberen Grenzfläche (2) um mindestens 20 $\mu$m überlappt.

8. Halbleiteranordnung nach Anspruch 6, dadurch gekennzeichnet, dass das Element (1) im Elektrodenbereich eine Dicke $(W_1+W_2+W_3)$ von mindestens 200 $\mu$m aufweist.

9. Halbleiteranordnung nach Anspruch 6 und Anspruch 8, dadurch gekennzeichnet, dass die n-leitende Basis (7) einen Abstand $(W_3)$ von mindestens 110 $\mu$m zwischen den angrenzenden p-leitenden Bereichen gewährleistet.

10. Halbleiteranordnung nach Anspruch 9, dadurch gekennzeichnet, dass der die n-leitende Basis (7) von der Anode (6) trennende Bereich eine Dicke $(W_2)$ von mindestens 40 $\mu$m aufweist.

11. Halbleiteranordnung nach Anspruch 9, dadurch gekennzeichnet, dass der Uebergang zwischen der n-leitenden Basis (7) und dem kathodenseitig angrenzenden p-leitenden Bereich in seinem zentralen Teil einen Abstand $(W_1)$ von mindestens 50 $\mu$m von der oberen Grenzfläche aufweist.

12. Halbleiteranordnung nach Anspruch 8, dadurch gekennzeichnet, dass die Grubentiefe (H) zwischen 70 und 90 $\mu$m beträgt.

13. Halbleiteranordnung nach Anspruch 6, dadurch gekennzeichnet, dass mehrere steuerbare Silizium-Halbleiterelemente (1) mit dem p-leitenden Bereich ihrer Randpartie (8) aneinandergrenzend in einer Halbleiterscheibe (20) angeordnet sind, und dass die Gruben (9) an der unteren Grenzfläche (3) in den genannten p-leitenden Bereichen zwischen den einzelnen Elementen (1) verlaufen und ein gitterartiges Muster bilden.

## Fig.1

## Fig. 2

## Fig.3

0031898

Europäisches Patentamt

# EUROPÄISCHER RECHERCHENBERICHT

Nummer der Anmeldung

EP 80 10 7491.5

| | EINSCHLÄGIGE DOKUMENTE | | KLASSIFIKATION DER ANMELDUNG (Int. Cl ³) |
|---|---|---|---|
| Kategorie | Kennzeichnung des Dokuments mit Angabe, soweit erforderlich, der maßgeblichen Teile | betrifft Anspruch | |
| X | <u>FR - A1 - 2 410 363</u> (SILICIUM SEMI-CONDUCTEUR) <br> * Ansprüche 1, 4, 5, 7; <br> Seite 1, Zeile 28 bis Seite 3, <br> Zeile 1; Seite 3, Zeilen 14 bis 30; <br> Seite 4, Zeilen 19 bis 34; Fig. 3 * <br> --- | 1,8,13 | H 01 L 21/78 <br> H 01 L 29/06 <br> H 01 L 29/743 <br> H 01 L 21/302 |
| | <u>DE - A1 - 2 900 747</u> (HITACHI LTD.) <br> * Ansprüche 1,6,7; Seite 7, Absatz 2; <br> Seite 8, Absatz 2; Seite 10, <br> letzter Absatz; Fig. 1e, 1f * <br> -- | 1,2,13 | RECHERCHIERTE SACHGEBIETE (Int. Cl.³) |
| | <u>US - A - 3 574 009</u> (UNITRODE CORP.) <br> * Spalte 4, Zeilen 5 bis 33; <br> Fig. 4 bis 6 * <br> -- | 1,2,8 | H 01 L 21/22 <br> H 01 L 21/302 <br> H 01 L 21/78 <br> H 01 L 21/94 <br> H 01 L 29/06 <br> H 01 L 29/74 |
| A | <u>US - A - 3 845 495</u> (SIGNETICS CORP.) <br> * Anspruch 1; Spalte 1, Zeilen 24 bis <br> 43, Spalte 5, Zeilen 36 bis 64; <br> Fig. 7, 9 * <br> ---- | 7 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 24-03-1981 | GIBBS |

EPA form 1503.1 06.78